# EUROPEAN PATENT SPECIFICATION

(11) **EP 0 368 444 B1**
(45) Date of publication and mention of the grant of the patent: **15.06.1994**
(21) Application number: 89308120.8
(22) Date of filing: 10.08.1989
(51) Int. Cl.: H01L 29/10, H01L 29/08, H01L 29/784

(54) **Semiconductor device, e.g. field-effect transistor, and method of producing the same**
Halbleitereinrichtung, z.B. Feldeffekttransistor, und Verfahren zur Herstellung derselben
Dispositif semi-conducteur, p.ex. transistor à effet de champ, et méthode pour sa fabrication

(30) Priority: 18.08.1988 JP 205535/88
(43) Date of publication of application: 16.05.1990
(73) Proprietor: SEIKO EPSON CORPORATION, Shinjuku-ku Tokyo-to (JP)
(72) Inventor: Takeuchi, Masahiro c/o SEIKO EPSON CORPORATION, Suwa-shi Nagano-ken (JP)
(74) Representative: Sturt, Clifford Mark

(56) References cited:
- EP-A- 0 209 166
- IEEE TRANSACTIONS ON ELECTRON DEVICES, vol. ED-29, no. 4, April 1982, pages 607-610, IEEE, New York, US; H. SUNAMI et al.: "Characteristics of a buried-channel graded drain with punchthrough stopper (BGP) MOS device"

## Description

The present invention relates to a semiconductor device and, in particular, although not essentially, the present invention relates to the construction of a MOS or MIS semiconductor device.

Recently, there has been a trend towards increasing levels of circuit integration for semiconductor devices. Consequently, the circuit dimensions of MOS type transistors have become very small, even reaching sub-micron levels. If such a trend towards smaller circuit dimensions continues, a phenomenon called punch-through can take place, in which a current flows between the source and the drain of the transistor, irrespective of the voltage applied to the gate. To solve this problem, methods for increasing the density of impurities in a portion below the surface of the transistor are known, as disclosed in JP-B-16194/1979, JP-B-127273/1978, JP-B-180167/1985 and JP-B-235471/1985. An example of such a method will be described with reference to Figure 2.

Reference numeral 201 denotes a p-type semiconductor substrate, such as a P-type silicon substrate; reference 202 identifies an element isolating insulation film and reference 203 denotes a gate insulating film. Reference 209 denotes a source region and a drain region, both of which are formed of an n-type layer of high-concentration impurities and reference 205 identifies a gate electrode. Reference 204 denotes a p-type layer of impurities having a higher concentration of impurities than the semiconductor substrate 201. Even if the depletion layer of the drain spreads on application of a voltage to the drain, the spreading of the depletion layer is held by the p-type layer of impurities 204, thereby preventing the punch-through effect.

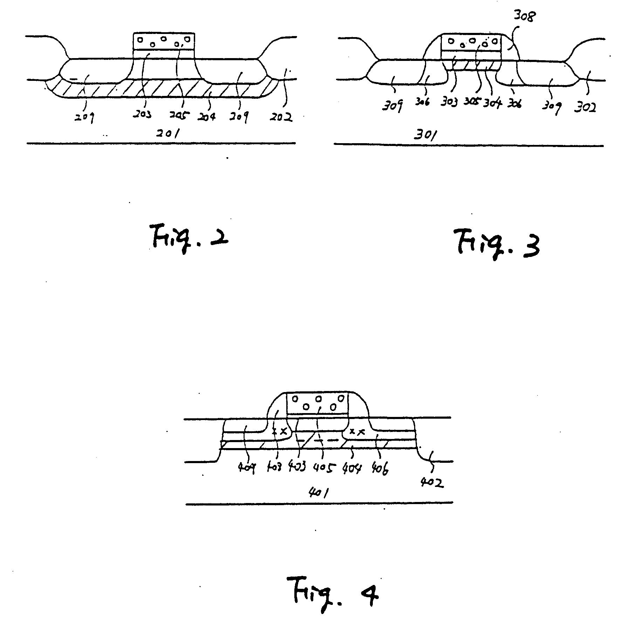

In addition, if the trend towards smaller circuit dimensions continues, while the level of the supply voltage remains fixed, deterioration of characteristics occur due to hot carriers. To solve this problem, a structure called lightly doped drain (LDD) has been proposed. A construction in which further improvements have been made to the LDD structure is disclosed by Ching-Yeu Wei, J. M. Pimbley and Y. Nissan-Cohen, in an article entitled "Buried and Graded/Buried LDD structures for Improved Hot-Electron Reliability", IEEE Electron Device Letters, Vol. EDL-7, No. 6 pp. 380-382, of June 1986. This type of structure will be described with reference to Figure 3.

A P-type silicon substrate 301 is formed of a p-type semiconductor having an element isolating insulating film 302 formed of an oxide film or the like. In addition, a gate 303 insulating film is formed of an oxide film or the like and the device includes a gate electrode 305, source regions and drain regions 309, both of which are formed of a n-type layer of high concentration impurities, source regions and drain regions 306, both of which are formed of an n-type layer of low concentration impurities. Furthermore, the device is provided with side wall insulating films 308 and a p-type layer 304 of impurities, having a higher concentration of impurities than the semiconductor substrate 301.

The source region and the drain region formed of the end-type layer 306, of low-concentration impurities, are deeper than the channel of an MOS type transistor and extend inwardly of the gate electrode 305. As a result, since the passage of a current flowing through the channel is bent downwardly at the drain end and a spot at which hot carriers are generated also moves to the inside of the substrate 301, the frequency at which the generated hot carriers jump into the interface between the gate oxide film and the channel is reduced, thereby minimizing the deterioration rate of the MOS transistor due to hot carriers.

However, since in the known example shown in Figure 2, the concentration of impurities in a portion deeper than a substrate surface is made higher, a punch through is unlikely to occur. Nevertheless, since no measures have been taken with respect to the concentration of an electrical field in the vicinity of the drain, there has been a problem in that the characteristics deteriorate due to hot carriers.

In addition, although in the known example shown in Figure 3, deterioration of the characteristics due to hot carriers is minimised, there has been a drawback in that, since the source regions and the drain regions 306 project inwardly of the gate electrode 305, a drain depletion layer and a source depletion layer are liable to be connected to each other, possibly resulting in a punch-through. Furthermore, since the threshold voltage of the MOS transistor is also involved, if the p-type layer 304, having a concentration of impurities higher than that of the semiconductor substrate 301, is formed in the vicinity of the surface of the semiconductor substrate 301, an avalanche phenomenon is liable to occur in the vicinity of the surface, with the result that there can be considerable deterioration of the MOS transistor.

An attempt to combine the techniques identified above is disclosed in IEEE Transactions on Electron Devices, ED-29607-610 (1982). The device is described as a buried-channel graded drain with punch through stopper. However, its operational characteristics are less than ideal, given that compromises are required to one aspect of the device, when implementing the second aspect of the device.

It is an object of the present invention to provide an improved semiconductor device.

According to a first aspect of the present invention, there is provided a semiconductor device comprising a semiconductor substrate of a first conductive type having a first concentration of impurities therein; a first impurity layer of said first conductive type formed in said substrate and having a second concentration of impurities higher than that of said first concentration; a gate electrode formed on said semiconductor substrate and separated therefrom by a first insulating film; a second impurity layer of a second conductive type, portions of which are formed in said semiconductor substrate on opposite sides of said gate electrode so as to be mutually spaced apart; said second impurity layer having a third concentration of impurities therein; a side wall insulating film formed on a side wall of said gate electrode; and a third impurity layer of said second conductive type formed in said semiconductor substrate laterally of said side wall insulating film, said third impurity layer having a fourth concentration of impurities therein higher than said third concentration, characterised in that said first impurity layer is formed in the semiconductor substrate so as to be spaced apart from a surface of the latter; and the surface of the second impurity layer furthest from said surface of the semiconductor abuts the first impurity layer or is disposed above said first impurity layer.

Preferably, the impurities in said first impurity layer are at a depth of 0.2 »m to 0.7 »m from the surface of the semiconductor substrate. Preferably, said second concentration is in the range of 10¹⁶ cm⁻³ to 3 x 10¹⁸cm⁻³.

Preferably, the impurities in said second impurity layer are at a depth of 0.05 »m to 0.25 »m.

Preferably the said third concentration is in the range 1 x 10¹⁶cm⁻³ to 6 x 10¹⁸cm⁻³.

Preferably, the third impurity layer is formed in the second impurity layer.

The device may be made by a method comprising forming the first insulating film on the semiconductor substrate; ion-implanting first impurities of said first conductive type into said semiconductor substrate in such a way that the peak of the concentration of said first impurities is disposed deeper than the surface of said semiconductor substrate; forming the gate electrode on said first insulating film; ion-implanting second impurities of said second conductive type into said semiconductor substrate with said gate electrode serving as a mask and in such a way that the peak of the concentration of said second impurities is shallower than the peak of the concentration of said first impurities; forming the side wall insulation film or films on said gate electrode; and ion-implanting third impurities of said second conductive type into said semiconductor substrate with said gate electrode and said side wall insulating film or films serving as masks.

Preferably, the second insulating film is formed on the semiconductor substrate and gate electrode, the said side wall insulating film or films being formed by effecting anisotropic ion-etching of the said second insulating film.

The invention enables an MOS transistor to be made in which a punch-through is unlikely to occur even if the circuit dimensions thereof are very small and in which the deterioration of characteristics thereof due to hot carriers is minimized, thereby overcoming the above-described drawbacks of the prior art.

The invention is illustrated, merely by way of example, in the accompanying drawings, in which:-
Figures 1(a) to 1(h) are cross-sectional views of steps employed in one embodiment of a method of producing a semiconductor device in accordance with the present invention, Figure 1(h) being a schematic cross-sectional view illustrating a first embodiment of a semiconductor device in accordance with the present invention;
Figures 2 and 3 are schematic cross-sectional views of known semiconductor devices;
Figure 4 is a schematic cross-sectional view illustrating a second embodiment of a semiconductor device according to the present invention;
Figure 5 is a graph showing the significance of Gm_{MAX};
Figure 6 is a graph showing the significance of L_{punch};
Figures 7 and 8 are graphs illustrating the profile of impurities in the direction of the depth of a substrate of the semiconductor device;
Figures 9 to 12 are graphs respectively illustrating the deterioration rate of Gm_{MAX} due to hot carriers and the minimum dimensions of L_{punch} at which a punch-through takes place; and
Figure 13 is a graph illustrating the time dependence of deterioration in Gm_{MAX} due to hot carriers in a MOS transistor, in which A indicates the embodiment of Figure 1(h), while B indicates a known example.

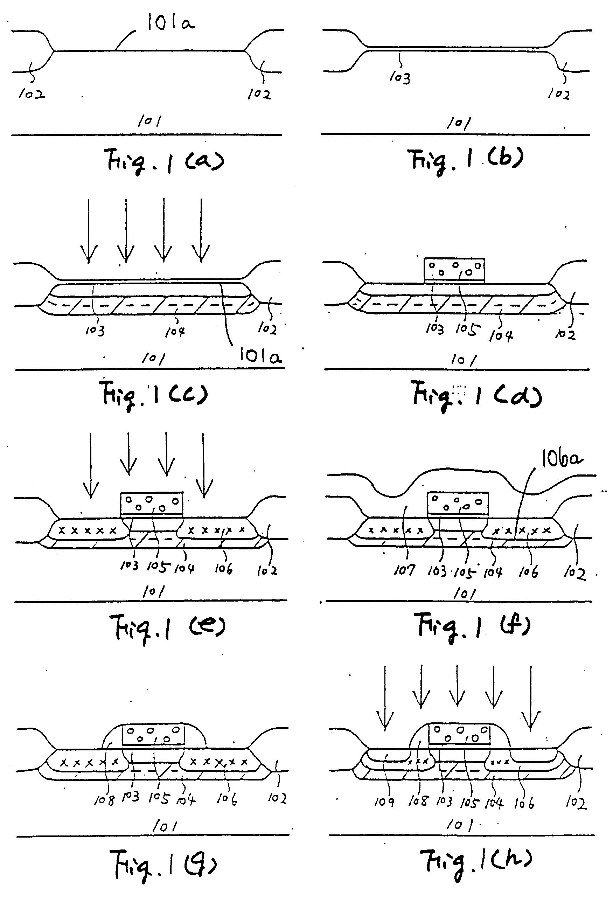

A detailed description will now be given of a first embodiment of the present invention with reference to Figures 1(a) to (h). Figure 1(h) is a cross-sectional view of a MOS transistor in accordance with the present invention, in a final step of its production. As shown in this drawing, the MOS transistor in accordance with the present invention comprises a semiconductor substrate 101, e.g. a p-type silicon substrate having a first concentration of impurities therein; an element isolating insulation film 102, e.g. a silicon oxide film; 103, a first insulating film, such as a gate insulating film constituted by a silicon oxide film; a first impurity layer constituted by a p-type belt-shaped layer 104 which is formed in the semiconductor substrate 101 and which has a second concentration of impurities therein at a concentration higher than the first concentration present in the silicon substrate 101; a gate electrode 105 formed on the semiconductor substrate 101 by way of the first insulating film 103; source and drain regions 106 formed by an n-type layer of low-concentration impurities, the layer 106 forming a second impurity layer portions of which are formed in the semiconductor substrate 101 on opposite sides of the gate electrode 105 so as to be spaced apart from each other, the layer 106 having a third concentration of impurities therein; 108, side wall insulating films formed of a silicon oxide film 107 or the like, the side wall insulating films 108 being formed on the side walls of the gate electrode 105; and source and drain regions 109 formed by an n-type third impurity layer of high-concentration impurities. The layer 109 is formed in the layer 106 laterally of the side wall insulating films 108 and has a fourth concentration of impurities therein which is higher than the said third concentration. The marks - indicate a position at which concentration of impurities of the p-type layer of concentration impurities become a maximum. The marks X indicate a position at which the concentration of impurities of the n-type layer of low-concentration impurities becomes a maximum.

First, a semiconductor substrate of a first conductive type, i.e. the p-type silicon substrate 101 in this case, is subjected to oxidation at 1,000°C in an oxidizing atmosphere so as to form a silicon oxide film with a 500 Å (5 x 10⁻⁸m) thickness. Subsequently, a silicon nitride film with a 200 Å (2 x 10⁻⁸m) is formed by the CVD (chemical vapour deposition) process. Then, after unnecessary portions of the silicon nitride film have been removed by a photoetching process, the silicon substrate 101 is subjected to oxidation at 1,000°C in a wet atmosphere to form an element isolating insulation film 102 constituted by an oxide film with a thickness of approximately 1 »m, and the aforementioned silicon nitride film is then removed. Through these processes, the silicon oxide film which serves as the element isolating insulation film 102 is formed on the p-type silicon substrate 101, as shown in Figure 1(a).

Subsequently, the p-type silicon substrate 101 is subjected to oxidation at 1,000°C in an oxidizing atmosphere, and a gate insulating film 103 constituted by an oxide film with a 200 Å (2 x 10⁻⁸m) thickness is formed on the p-type silicon substrate 101, as shown in Figure 1(b). Then, as shown in Figure 1(c), p-type impurities, e.g. boron, are ion implanted at a dosage of 1 x 10¹²cm⁻² to 1 x 10¹⁴cm⁻² and at an acceleration voltage of 60 KeV to 200 KeV to form the p-type layer 104 having an impurity concentration higher than that of the silicon substrate. The layer 104 is formed in the semiconductor substrate 101 so as to be spaced apart from a surface 101a of the latter, the impurities in the layer 104 being at a first depth from the surface 101a.

Then, as shown in Figure 1(d), after a polycrystalline silicon film having a thickness of 6,000 Å (6 x 10⁻⁷m) is formed by the CVD process, unnecessary portions are removed by the photoetching process so as to form the gate electrode 105.

Subsequently, as shown in Figure 1(e), n-type impurities, e.g. phosphorus, are ion-implanted at a dosage of 1 x 10⁻¹²cm⁻² to 1 x 10¹⁴cm⁻² and at an acceleration voltage of 80 KeV to 180 KeV with the gate electrode 105 and the element isolating insulation film 102, constituted by the silicon oxide film, serving as masks so as to form the n-type layer 106 of low-concentration impurities for the source and drain regions. The second impurity layer has impurities therein at a second depth from the surface 101a of the semiconductor substrate 101, the surface 106a of the layer 106 which is lowermost in the position shown in the drawings, i.e. in the position in which the surface 101a is at the top of the device, abutting the layer 104, or, if desired, being above the latter.

Then, as shown in Figure 1(f), after the silicon oxide film 107 with a 6000 Å (6 x 10⁻⁷m) thickness has been formed on the semiconductor substrate 101 and on the gate electrode 105 by means of the CVD process, reactive anisotropic ion-etching is performed so as to form the side wall insulating film 108 formed by the silicon oxide film, as shown in Figure 1(g).

Subsequently, as shown in Figure 1(h), n-type impurities, e.g. arsenic, are ion-implanted at a dosage of 1 x 10¹⁶cm⁻² and at an acceleration voltage of 80 KeV with the gate electrode 105, the side wall insulating film 108, and the element isolating insulation film 102 serving as masks so as to form the n-type layer 109 of high-concentration impurities for the source and drain regions.

Finally, to activate the ion-implanted layers, the MOS transistor is subjected to annealing at 800°C to 1,100°C. In the case of the MOS transistor thus formed, if the concentration of the p-type impurities of the p-type silicon substrate 101, i.e. the concentration of impurities of boron in this case, is set at 5 x 10¹⁵ cm⁻³, the maximum value of the concentration of impurities of the n-type layer 106 of low-concentration impurities is 1 x 10¹⁶cm⁻³ to 6 x 10¹⁸cm⁻³, and the position at which the value becomes a maximum is 0.05 to 0.25 »m deep from the surface of the silicon substrate 101, so that the n-type layer 106 of low-concentration impurities projects 0.05 to 0.15 »m inwardly of the gate electrode 105.

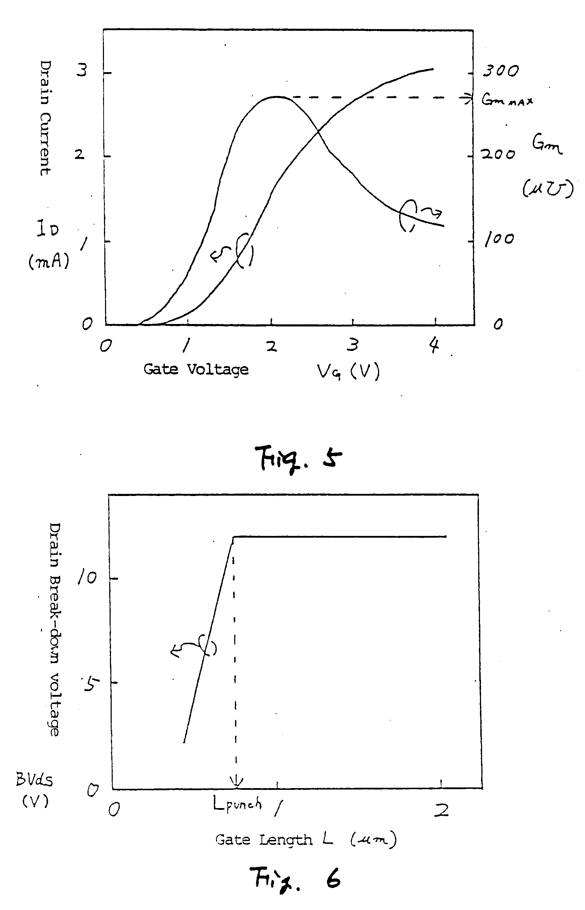

Figure 4 shows a construction closely similar to that of Figure 1(h), parts of the construction of Figure 4 having similar reference numerals to the corresponding parts of Figure 1 with the addition of 300. In the Figure 4 construction, however, the element isolating insulation film 402 constitutes a trench type element isolating insulation region.

Figure 9 is a graph illustrating the depth of the position at which the concentration of impurities of the n-type layer 106 of low-concentration impurities becomes a maximum, the deterioration rate of Gm due to hot carriers, and the minimum dimension at which a punch-through takes place.

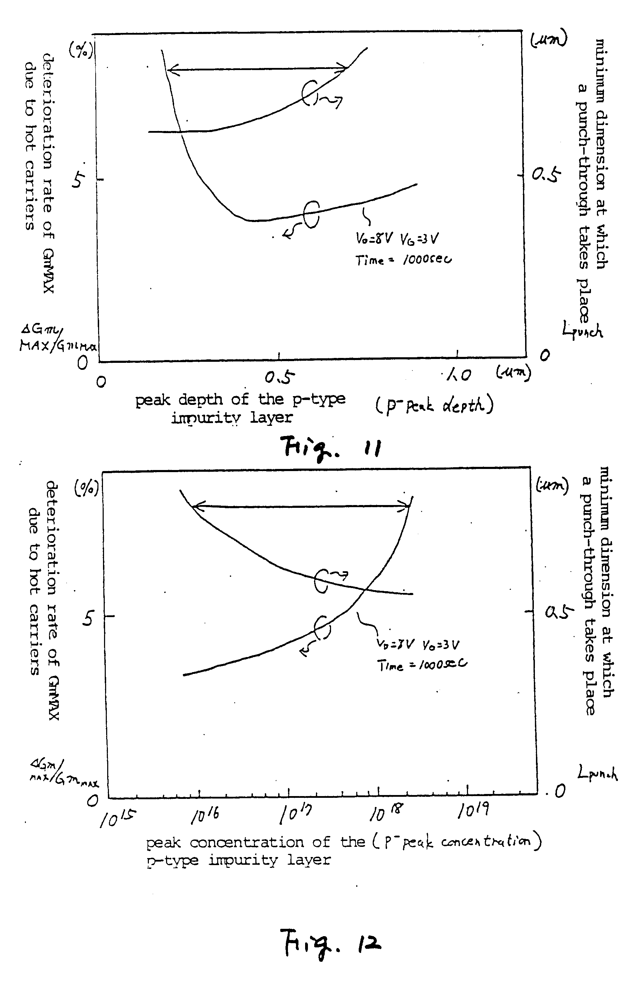

Figure 10 is a graph illustrating the value at which the concentration of the n-type layer 106 of low-concentration impurtities becomes a maximum, the deterioration rate of Gm_{MAX} due to hot carriers, and the minimum dimension at which a punch-through takes place.

With regard to Gm_{MAX} referred to herein, a value obtained by differentiating I_{D} with V_{G} in the graph of a gate voltage V_{G} and a drain current I_{D} of the MOS transistor, as shown in Figure 5, is Gm, and its maximum value is indicated as Gm_{MAX}. In addition, with regard to the minimum dimension at which a punch-through takes place, if a graph is plotted with respect to a drain breakdown voltage BVds and a gate length L when the gate is connected to ground, as shown in Figure 6, if the gate length L becomes shorter than a certain gate length, BVds starts to decline. Such a gate length is specified as a minimum dimension L_{punch} at which a punch-through takes place.

Both Figures 9 and 10 show favourable values with respect to both the deterioration rate of Gm_{MAX} due to hot carriers and the minimum dimension at which a punch-through takes place in accordance with the range of the above-described embodiment. This can be considered as follows. The deeper is the position from the substrate surface at which the concentration of impurities of the n-type layer 106 of low-concentration impurities becomes a maximum, the deeper from the substrate surface is the spot at which hot carriers are generated in the vicinity of the drain, so that the rate of deterioration of Gm_{MAX} due to hot carriers becomes small. However, since a punch-through is otherwise liable to occur, it is impossible to lower the position unduly. There is an optimum range for this position. Furthermore, the effect of alleviation of an electric field in the vicinity of the drain changes due to the concentration of impurities of the n-type layer 106 of low-concentration impurities, so that the rate of deterioration of Gm_{MAX} also changes. In other words, the rate of deterioration of Gm_{MAX} due to hot carriers becomes large if this concentration of impurities is too rich or too lean. In addition, since the tendency of occurrence of a punch-through also changes due to this concentration of impurities, there is an optimum range. If it is assumed that the deterioration rate of Gm_{MAX} due to hot carriers is 8% or less and the minimum dimension at which a punch-through takes place is 0.8 micron, an optimal range of the position at which the concentration of impurities of the n-type layer 106 of low-concentration impurities becomes a maximum can be determined from Figure 9 to be 0.05 to 0.25 »m from the surface of the silicon substrate, preferably 0.08 to 0.2 micron for reducing the deterioration rate of Gm_{MAX} due to hot carriers, or still more preferably 0.1 to 0.18 microns. In addition, if it is assumed that the deterioration rate of Gm_{MAX} due to hot carriers is 8% or below and the minimum dimension at which a punch-through takes place is 0.8 micron, the optimal range of the concentration of impurities of the n-type layer 106 of low-concentration impurities can be determined from Figure 10 to be in the range of 1 x 10¹⁶cm⁻³ to 6 x 10¹⁸cm⁻³, preferably 2 x 10¹⁶cm⁻³ to 2 x 10¹⁸cm⁻³ for reducing the deterioration rate of Gm_{MAX} due to hot carriers, or still more preferably 1 x 10¹⁷cm⁻³ to 1 x 10¹⁸cm⁻³. In accordance with the above-described embodiment, the position at which the concentration of impurities of p-type impurity layer 104 have a concentration higher than that of the silicon substrate is at a depth of 0.2 »m to 0.55 »m.

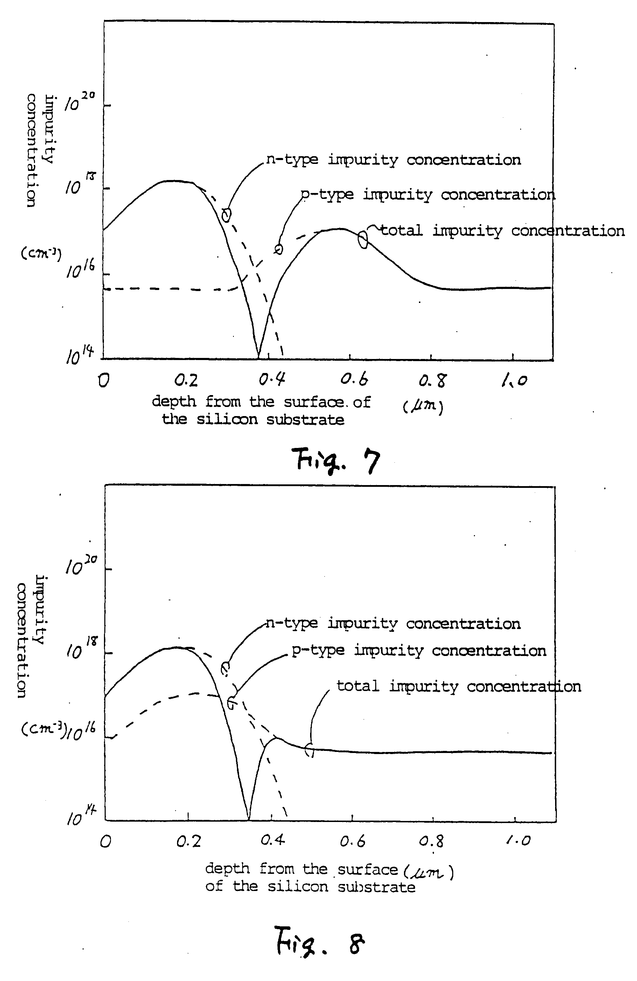

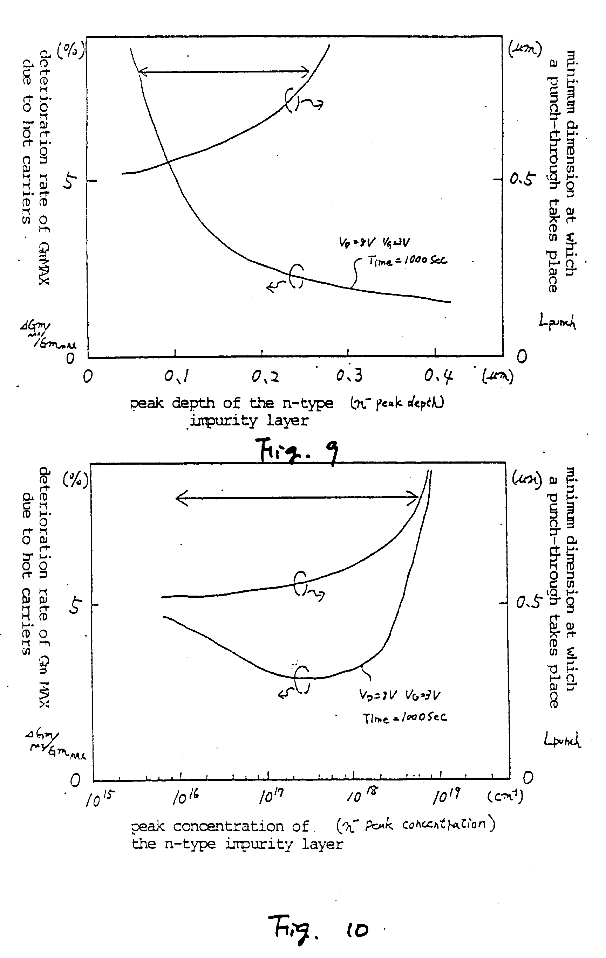

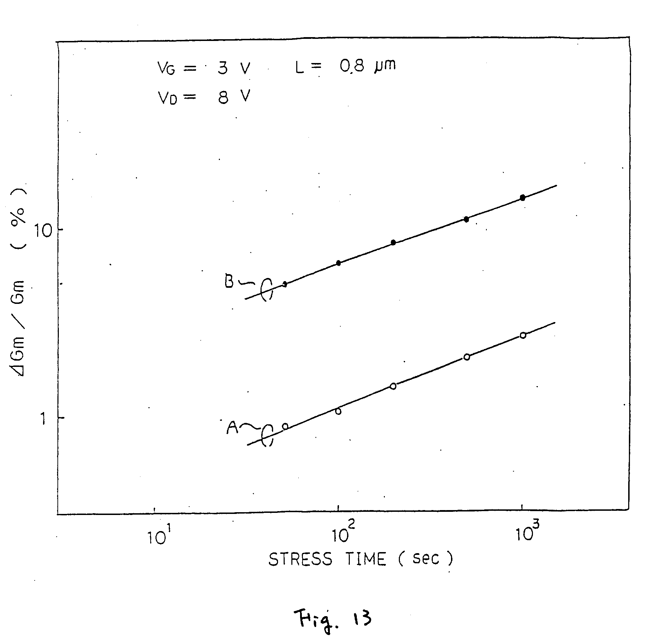

Figures 7 and 8 show the profile of impurities in the direction of the depth of the n-type layer 106 of low-concentration impurities and the p-type impurity layer 104 in this case. Figure 7 shows the profile of impurities at a depth of 0.15 »m at which the concentration of impurities of the n-type layer 106 of low-concentration impurities become a maximum and at a depth of 0.55 »m, at which the concentration of impurities of the p-type impurity layer 104 becomes a maximum. Figure 8 shows the profile of impurities at a depth of 0.15 »m at which the concentration of impurities of the n-type layer 106 of low-concentration impurities become a maximum and at a depth of 0.2 micron at which the concentration of impurities of the p-type impurity layer 104 becomes a maximum. As can be seen from these Figures, looking at the overall concentration of impurities in which n-type impurities and p-type impurities are offset with respect to each other, a p-type region having a higher concentration of impurities than that of the silicon substrate is present at a location deeper than the n-type layer 106 of low-concentration impurities. In this case, both the deterioration rate of Gm_{MAX} due to hot carriers and the minimum dimension at which a punch-through takes place show favourable values in Figures 11 and 12 in the range of the above-described embodiment.

This can be considered as follows: If a p-type layer 104 having a higher concentration of impurities than that of the silicon substrate 101 is formed at a position deeper than the n-type layer 106 of low-concentration impurities due to the p-type impurity layer 104, the spreading of the drain depletion layer can be held, so that it becomes difficult for a punch-through to take place. However, this does not mean that the position can be set at an unduly deep position. If the location of the p-type impurity layer 104 is set too deep, the depth of the p-type impurity layer 104 becomes greater than that of the spreading region of the drain depletion layer, so that it becomes impossible to restrain the spreading of the drain depletion layer, with the result that a punch-through is liable to occur.

In addition, since the position at which the concentration of impurities of the p-type impurity layer 104 becomes a maximum is set deep, the spot where the avalanche phenomenon occurs in the vicinity of a drain due to a drain electric field is brought to a position which is deep with respect to the substrate, and the deterioration rate of Gm due to hot carriers is lowered. Nevertheless, even if the depth of the p-type impurity layer 104 is set lower than a certain position, the spot where the avalanche phenomenon occurs does not change, so that the deterioration rate of Gm_{MAX} is not improved to a substantial extent.

As will be appreciated from the foregoing description, an optimal range exists with respect to the position where the concentration of impurities of the p-type impurity layer 104 becomes a maximum. If it is assumed that the deterioration rate of Gm_{MAX} due to hot carriers is 8% or less and that the minimum dimension at which a punch-through takes place is 0.8 micron, the optimal range can be determined from Figure 11 as being in the range of 0.2 »m to 0.7 »m from the surface of the silicon substrate, preferably 0.25 »m to 0.55 »m or still more preferably 0.3 »m to 0.5 »m from the surface where hot carriers and the punch-through takes place.

In addition, Figure 12 is a graph illustrating the maximum value of the concentration of densities of the p-type impurity layer 104, the deterioration rate of Gm_{MAX} due to hot carriers, and the minimum dimension at which a punch-through takes place. From this graph, the range of the maximum value of the concentration of impurities of the p-type impurity layer 104 can be determined to be in the range of 1 x 10¹⁶cm⁻³ to 3 x 10¹⁸cm⁻³, preferably 4 x 10¹⁶cm⁻³ to 2 x 10¹⁸cm⁻³, and still more preferably 1 x 10¹⁷ cm⁻³ to 1 x 10¹⁸cm⁻³.

Figure 13 is a graph illustrating the time dependence of deterioration of Gm due to hot carriers in MOS transistors according to the embodiment of Figure 1(h) and in a known example, in which A indicates the embodiment of Figure 1(h), while B indicates the known example. Figure 13 shows that the deterioration rate of Gm in accordance with the embodiment of Figure 1(h) becomes approximately 1/5 that of the known example.

Although in the embodiment of Figure 1(h) boron is used as to the p-type impurities of the p-type impurity layer 104, aluminium, gallium, or indium may alternatively be used, or a combination of such impurities, such as boron and aluminium may be used. In addition, although phosphorus is used as the n-type impurities in the n-type layer 106 of low-concentration impurities, arsenic or antimony may be used, or a combination of such impurities, such as arsenic and phosphorus may be used.

In addition, although in the embodiment of Figure 1(h) a polycrystalline silicon film is used for the gate electrode 105, a refractory metal such as titanium, molybdenum, or tungsten may be used, or a refractory metal polycide film in which a refractory metal such as titanium, molybdenum, or tungsten or a silicide thereof is formed on a semiconductor film such as a polycrystalline silicon film, or a refractory metal itself or a silicide thereof itself may be used. Furthermore, although in the embodiment of Figure 1(h) a silicon oxide film formed by the CVD process is used as the side wall insulating film 108, a silicon oxide film obtained by thermally oxidizing a polycrystalline silicon film may be used, or a silicon nitride film may be used. Moreover, although in this embodiment of Figure 1(h) the element isolating region 102 is formed by the LOCOS process, it is possible to use the trench isolation process in which, after a trench is provided in the semiconductor substrate, the one obtained by embedding the trench with an insulating film such as an oxide film is used as the element isolating region 402 (Figure 4).

In the embodiment of Figure 1(h), if the transistor shown is used as a transistor constituting a flip-flop of a memory cell of an SRAM, strong protection can be obtained against soft errors caused by alpha particles. If alpha particles penetrate into the n-type diffusion layer in a drain region of the transistor constituting a flip-flop of an SRAM,, pairs of electrons and holes are generated in a depletion layer formed between an N+ diffusion layer and a p-type substrate. The generated electrons are drawn by an electrical field in the direction of the drain of the transistor and are injected into the drain diffusion layer. At this time, if the drain diffusion layer is in the high state of the flip-flop, the potential is lowered by the injected electrons, so that the high state turns to the low state. This is a soft error due to alpha particles. However, in the embodiment shown in Figure 1(h), even if the drain diffusion layer is in the high state, the width of the depletion layer becomes narrow due to the n-type impurity layers 106, 109 and the p-type impurity layer 104. In this case, even if alpha particles penetrate into the n-type diffusion layer in the drain region, since the width of the aforementioned depletion layer is made narrow, the number of pairs of electrons and holes generated in the depletion layer will be small, so that strong protection against soft errors caused by alpha particles can be obtained.

Although in relation to the embodiment of Figure 1(h) a description has been given of an n-channel transistor, it goes without saying that a similar effect can be obtained if the present invention is applied to a p-channel transistor.

In a semiconductor device according to the present invention, since a punch-through phenomenon is unlikely to occur, MOS transistors can be provided with very short channels up to submicron regions, which allows not only high levels of integration and high speed of LSI's to be attained but also the rate of deterioration of characteristics due to hot carriers can be minimized. In addition, if the MOS device is used for a memory cell of an SRAM, its protection against soft errors caused by alpha particles can be enhanced. Hence, the present invention is of substantial value in improving the reliability of LSI's.

## Claims

1. A semiconductor device comprising
a semiconductor substrate (101) of a first conductive type having a first concentration of impurities therein;
a first impurity layer (104) of said first conductive type formed in said substrate (101) having a second concentration of impurities higher than that the said first concentration;
a gate electrode (105) formed on said semiconductor substrate (101) and separated therefrom by a first insulating film (103);
a second impurity layer (106) of a second conductive type, portions of which are formed in said semiconductor substrate (101) on opposite sides of said gate electrode (105), so as to be mutually spaced apart, said second impurity layer (106) having a third concentration of impurities therein;
a side wall insulating film formed on a side wall of said gate electrode (105); and
a third impurity layer (109) of said second conductive type formed in said semiconductor substrate (101) laterally of said side wall insulating film (108), said third impurity layer (109) having a fourth concentration of impurities therein higher than said third concentration, characterised in that
said first impurity layer (104) is formed in the semiconductor substrate (101) so as to be spaced apart from a surface (101a) of the latter; and
the surface (106a) of the second impurity layer (106) furthest from said surface (101a) of the semiconductor substrate abuts the first impurity layer (104) or is disposed above said first impurity layer.

2. A device according to claim 1, wherein the impurities in said first impurity layer (104) are at a depth of 0.2 »m to 0.7 »m from the surface of the substrate.

3. A device according to claim 1 or claim 2, wherein said second concentration is in the range of 1 x 10¹⁶cm⁻³ to 3 x 10¹⁸cm⁻³.

4. A device according to any preceding claim, wherein the impurities in said second impurity layer (106) are at a depth of 0.05 »m to 0.25 »m.

5. A device according to any preceding claim, wherein said third concentration is in the range 1 x 10¹⁶cm⁻³ to 6 x 10¹⁸cm⁻³.

6. A device according to any preceding claim, wherein the third impurity layer (109) is formed in the second impurity layer (106).

7. A method of producing a semiconductor device according to any preceding claim, wherein the device is made by forming the first insulating film (103) on the semiconductor substrate (101);
ion-implanting first impurities of said first conductive type into said semiconductor substrate (101) in such a way that the peak of the concentration of said first impurities is disposed deeper than the surface (101a) of said semiconductor substrate (101);
forming a gate electrode (105) on said first insulating film (103);
ion implanting second impurities of said second conductive type into said semiconductor substrate (101) with said gate electrode (105) serving as a mask and in such a way that the peak of the concentration of said second impurities is shallower than the peak of the concentration of said first impurities;
forming the side wall insulation film on said gate electrode (105); and
ion implanting third impurities of said second conductive type into said semiconductor substrate (101) with said gate electrode (105) and said side wall insulating film (108) serving as masks.

8. A method according to claim 7, wherein a second insulating film (107) is formed on the semiconductor substrate (101) and gate electrode (105), said side wall insulating film (108) being formed by effecting anisotropic ion etching of said second insulating film (107).

## Patentansprüche

1. Halbleiterbauteil, umfassend
ein Halbleitersubstrat (101) eines ersten Leitungstyps mit einer ersten Fremdstoffkonzentration darin;
eine in dem Substrat (101) gebildete erste Fremdstoffschicht (104) des ersten Leitungstyps, welche eine zweite Fremdstoffkonzentration aufweist, die höher ist als die erste Konzentration;
eine auf dem Halbleitersubstrat (101) gebildete und durch eine erste isolierende Schicht (103) von diesem getrennte Gate-Elektrode (105);
eine zweite Fremdstoffschicht (106) eines zweiten Leitungstyps, von welcher Abschnitte in dem Halbleitersubstrat (101) auf entgegengesetzten Seiten der Gate-Elektrode (105) gebildet sind, so daß sie zueinander im Abstand angeordnet sind, wobei die zweite Fremdstoffschicht (106) eine dritte Fremdstoffkonzentration darin aufweist;
eine an einer Seitenwand der Gate-Elektrode (105) gebildete Seitenwandisolationsschicht; und
eine dritte Fremdstoffschicht (109) des zweiten Leitungstyps, welche in dem Halbleitersubstrat (101) seitlich der Seitenwandisolationsschicht (108) gebildet ist, wobei die dritte Fremdstoffschicht (109) eine vierte Fremdstoffkonzentration darin aufweist, die höher ist als die dritte Konzentration,
**dadurch gekennzeichnet**,
daß die erste Fremdstoffschicht (104) in dem Halbleitersubstrat (101) derart ausgebildet ist, daß sie von einer Oberfläche (101a) des letzteren einen Abstand aufweist; und
daß die Oberfläche (106a) der zweiten Fremdstoffschicht (106) an ihrem am weitesten von der Oberfläche (101a) des Halbleitersubstrats entfernt gelegenen Bereich an der ersten Fremdstoffschicht (104) anstößt oder über der ersten Fremdstoffschicht angeordnet ist.

2. Bauteil nach Anspruch 1, worin die Fremdstoffe in der ersten Fremdstoffschicht (104) bei einer Tiefe von 0,2 »m bis 0,7 »m von der Oberfläche des Substrats sind.

3. Bauteil nach Anspruch 1 oder Anspruch 2, worin die zweite Konzentration im Bereich von 1 x 10¹⁶ cm⁻³ bis 3 x 10¹⁸ cm⁻³ liegt.

4. Bauteil nach einem der vorhergehenden Ansprüche, worin die Fremdstoffe in der zweiten Fremdstoffschicht (106) bei einer Tiefe von 0,05 »m bis 0,25 »m sind.

5. Bauteil nach einem der vorhergehenden Ansprüche, worin die dritte Konzentration im Bereich von 1 x 10¹⁶ cm⁻³ bis 6 x 10¹⁸ cm⁻³ liegt.

6. Bauteil nach einem der vorhergehenden Ansprüche, worin die dritte Fremdstoffschicht (109) in der zweiten Fremdstoffschicht (106) gebildet ist.

7. Verfahren zur Herstellung eines Halbleiterbauteils nach einem der vorhergehenden Ansprüche, worin das Bauteil hergestellt wird, durch
Bilden der ersten isolierenden Schicht (103) auf dem Halbleitersubstrat (101),
Ionenimplantation erster Fremdstoffe des ersten Leitungstyps in das Halbleitersubstrat (101) derart, daß die Spitze der Konzentration der ersten Fremdstoffe tiefer liegt, als die Oberfläche (101a) des Halbleitersubstrats (101);
Bilden einer Gate-Elektrode (105) auf der ersten isolierenden Schicht (103);
Ionenimplantation zweiter Fremdstoffe des zweiten Leitungstyps in das Halbleitersubstrat (101), wobei die Gate-Elektrode (105) als Maske dient, und in einer derartigen Art und Weise, daß die Spitze der Konzentration der zweiten Fremdstoffe weniger tief liegt, als die Spitze der Konzentration der ersten Fremdstoffe;
Bilden der Seitenwandisolationsschicht auf der Gate-Elektrode (105); und
Ionenimplantation dritter Fremdstoffe des zweiten Leitungstyps in das Halbleitersubstrat (101), wobei die Gate-Elektrode (105) und die Seitenwandisolationsschicht (108) als Masken dienen.

8. Verfahren nach Anspruch 7, worin eine zweite isolierende Schicht (107) auf dem Halbleitersubstrat (101) und der Gate-Elektrode (105) gebildet wird, wobei die Seitenwandisolationsschicht (108) durch Durchführen eines anisotropen Ionenätzens der zweiten isolierenden Schicht (107) gebildet wird.

## Revendications

1. Dispositif semi-conducteur comprenant
un substrat semi-conducteur (101) d'un premier type conducteur, contenant une première concentration d'impuretés ;
une première couche d'impuretés (104) dudit premier type conducteur, formée dans ledit substrat (101), avec une deuxième concentration d'impuretés, supérieure à ladite première concentration ;
une grille (105) formée sur ledit substrat semi-conducteur (101) et qui en est séparée par un premier film isolant (103) ;
une deuxième couche d'impuretés (106) d'un deuxième type conducteur, dont des portions sont formées dans ledit substrat semi-conducteur (101) sur les côtés opposés de ladite grille (105), de façon à être espacées l'une de l'autre, ladite deuxième couche d'impuretés (106) contenant une troisième concentration d'impuretés ;
un film isolant la paroi latérale formé sur une paroi latérale de ladite grille (105) ; et
une troisième couche d'impuretés (109) dudit deuxième type conducteur, formée dans ledit substrat semi-conducteur (101) latéralement par rapport audit film isolant de paroi latérale (108), ladite troisième couche d'impuretés (109) ayant une quatrième concentration d'impuretés supérieure à ladite troisième concentration, caractérisé en ce que
ladite première couche d'impuretés (104) est formée dans le substrat semi-conducteur (101) de façon à se trouver à une certaine distance d'une surface (101a) de ce dernier ; et
la surface (106a) de la deuxième couche d'impuretés (106), située le plus loin de ladite surface (101a) du substrat semi-conducteur, entre en aboutement avec la première couche d'impuretés (104) ou est disposée au dessus de ladite première couche d'impuretés.

2. Dispositif selon la revendication 1, dans lequel les impuretés de ladite première couche d'impuretés (104) se trouvent à une profondeur de 0,2 à 0,7 »m à partir de la surface du substrat.

3. Dispositif selon la revendication 1 ou 2, dans lequel ladite deuxième concentration est comprise entre 1 x 10¹⁶cm⁻³ et 3 x 10¹⁸cm⁻³.

4. Dispositif selon l'une quelconque des revendications précédentes, dans lequel les impuretés de ladite deuxième couche d'impuretés (106) se trouvent à une profondeur de 0,05 à 0,25 »m.

5. Dispositif selon l'une quelconque des revendications précédentes, dans lequel ladite troisième concentration est comprise entre 1 x 10¹⁶cm⁻³ et 6 x 10¹⁸cm⁻³.

6. Dispositif selon l'une quelconque des revendications précédentes, dans lequel la troisième couche d'impuretés (109) est formée dans la deuxième couche d'impuretés (106).

7. Procédé pour produire un dispositif semi-conducteur selon l'une quelconque des revendications précédentes, dans lequel on prépare le dispositif en formant le premier film isolant (103) sur le substrat semi-conducteur (101) ;
on implante par implantation ionique des premières impuretés dudit premier type conducteur dans ledit substrat semi-conducteur (101) de façon que le pic de concentration desdites premières impuretés se trouve à une profondeur plus grande que la surface (101a) dudit substrat semi-conducteur (101) ;
on forme une grille (105) sur ledit premier film isolant (103) ;
on implante par implantation ionique des deuxièmes impuretés dudit deuxième type conducteur dans ledit substrat semi-conducteur (101), ladite grille (105) servant de masque de façon que le pic de concentration desdites deuxièmes impuretés soit moins haut que le pic de concentration desdites premières impuretés ;
on forme le film isolant de paroi latérale sur ladite grille (105) ; et
on implante par implantation ionique des troisièmes impuretés dudit deuxième type conducteur dans ledit substrat semi-conducteur (101), la grille (105) et le film isolant de paroi latérale (108) servant de masques.

8. Procédé selon la revendication 7, dans lequel on forme un deuxième film isolant (107) sur le substrat semi-conducteur (101) et la grille (105), le film isolant de paroi latérale (108) étant formé par attaque ionique anisotrope dudit deuxième film isolant (107).
